(19) Europäisches Patentamt
European Patent Office
Office européen des brevets

(11) Veröffentlichungsnummer: **0 295 545 B1**

(12) **EUROPÄISCHE PATENTSCHRIFT**

(45) Veröffentlichungstag der Patentschrift: **14.04.93**

(51) Int. Cl.$^5$: **G03F 7/032**

(21) Anmeldenummer: **88109080.7**

(22) Anmeldetag: **08.06.88**

# (54) Durch Photopolymerisation vernetzbare Heissprägeplatten.

(30) Priorität: **13.06.87 DE 3719871**

(43) Veröffentlichungstag der Anmeldung:
**21.12.88 Patentblatt 88/51**

(45) Bekanntmachung des Hinweises auf die Patenterteilung:
**14.04.93 Patentblatt 93/15**

(84) Benannte Vertragsstaaten:
**DE FR GB NL**

(56) Entgegenhaltungen:
**EP-A- 0 224 164**
**EP-A- 0 226 079**
**GB-A- 815 277**
**US-A- 4 517 277**

**PATENT ABSTRACTS OF JAPAN, Band 6, Nr. 211 (P-153)[1099], 5. November 1982 & JP-A-57 124 730 (TOUKIYOU OUKA KOGYO K.K.) 03-08-1982**

(73) Patentinhaber: **BASF Aktiengesellschaft**
**Carl-Bosch-Strasse 38**
**W-6700 Ludwigshafen(DE)**

(72) Erfinder: **Bronstert, Bernd, Dr.**
**Zanderstrasse 35**
**W-6701 Otterstadt(DE)**

EP 0 295 545 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft neue, in ihren anwendungstechnischen Eigenschaften verbesserte, durch Photopolymerisation vernetzbare Heißprägeplatten, welche

a) einen hitzebeständigen, dimensionsstabilen Träger und

b) eine durch Photopolymerisation vernetzbare, in Wasser lösliche oder dispergierbare, reliefbildende Schicht

aufweisen, wobei die reliefbildende Schicht (b)

$b_1$) einen oder mehrere partiell oder nahezu vollständig hydrolysierte Polyvinylalkohol-alkancarbonsäureester als Bindemittel,

$b_2$) einen oder mehrere Alkencarbonylamino-N-methylenether mehrwertiger Alkohole als photopolymerisierbare Monomere und

$b_3$) Initiatoren der Photopolymerisation

enthält.

Für partiell oder nahezu vollständig hydrolysierte Homo- und Copolymerisate von Vinylalkohol-alkancarbonsäureestern und für Pfropfmischpolymerisate auf dieser Basis hat sich die Bezeichnung "Polyvinylalkohol" eingebürgert. Im folgenden wird diese Bezeichnung der Kürze halber in diesem Sinn verwendet. Die Alkencarbonsäureester und die Alkencarbonvlamino-N-methylenether von Polyvinylalkoholen werden im folgenden auch kurz als "Polyvinylalkoholderivate" bezeichnet.

Dabei weist der Ausdruck "partiell hydrolysiert" darauf hin, daß 40 bis 98 Mol-% der in den Polymerisaten ursprünglich vorhandenen Alkancarbonsäureestergruppen zu hydroxygruppen hydrolysiert worden sind. Demgemäß bezeichnet der Ausdruck "nahezu vollständig hydrolysiert" einen Hydrolysegrad von mehr als 98 Mol-%.

Heißprägeplatten dienen dem Aufprägen bildmäßiger Informationen auf andere Materialien in der Hitze. So werden sie zum Prägen von Pappmatern für den Zeitungsdruck mittels sogenannter Stereos, zum Prägen von Kunststoff-Folien, z.B. aus Polyvinylchlorid, oder zum Prägen von Materplatten, welche der Herstellung von Flexodruckklischees dienen, verwendet.

Durch Photopolymerisation vernetzbare, in Wasser lösliche Gemische auf der Grundlage von Polvinylalkohol und von (Meth)Acrylamido-N-methylenethern mehrwertiger Alkohole sind aus der JP-A-124730/82 bekannt.

Außerdem sind aus der US-A-4 517 277 Gemische auf der Grundlage von Polyvinylalkohol, Polyvinylalkohol-alkencarbonsäureestern und von Acrylsäure- oder Methacrylsäureestern bekannt.

Des weiteren gehen aus der EP-A 226 079 monomerenfreie Gemische aus Alkencarbonylamino-N-methylenethern von Polyvinylalkohol hervor.

Die bekannten, durch Photopolymerisation vernetzbaren, in Wasser löslichen oder dispergierbaren Gemische der in Rede stehenden Art werden im allgemeinen für die Herstellung von reliefbildenden Schichten photopolymerisierbarer Aufzeichnungsmaterialien verwendet. Diese bekannten Aufzeichnungsmaterialien dienen vor allem der Herstellung von durch Photopolymerisation vernetzten Druckformen, Reliefformen oder Photoresistmustern. Sie eignen sich indes nur bedingt oder gar nicht für die Herstellung von Heißprägeplatten, weil sie nach der bildmäßigen Belichtung und Entwicklung nicht die hohe Härte und Temperaturfestigkeit aufweisen, wie die für Prägezwecke erforderlich sind. Außerdem weisen die reliefbildenden Schichten der bekannten Aufzeichnungsmaterialien bei einer Schichtdicke, wie sie für Heißprägeplatten erforderlich ist, schlechte Belichtungseigenschaften auf, so daß hiermit Bildvorlagen nur schlecht oder gar nicht reproduziert werden können.

Der Erfindung lag die Aufgabe zugrunde, neue, in ihren anwendungstechnischen Eigenschaften verbesserte, durch Photopolymerisation vernetzbare Heißprägeplatten zu finden, welche die Nachteile von Heißprägeplatten auf der Grundlage der bekannten photopolymerisierbaren Aufzeichnungsmaterialien nicht länger aufweisen.

Demgemäß wurden durch Photopolymerisation vernetzbare Heißprägeplatten gefunden, welche

a) einen hitzebeständigen, dimensionsstabilen Träger und

b) eine durch Photopolymerisation vernetzbare, in Wasser lösliche oder dispergierbare, reliefbildende Schicht, enthaltend

$b_1$) einen oder mehrere partiell oder nahezu vollständig hydrolysierte Polyvinylalkohol-alkancarbonsäureester als Bindemittel,

$b_2$) einen Alkencarbonylamino-N-methylenether mehrwertiger Alkohole als photopolymerisierbares Monomer und

$b_3$) Initiatoren der Photopolymerisation,

aufweisen und welche dadurch gekennzeichnet sind, daß die reliefbildende Schicht (b) als weitere Bindemit-

tel ($b_1$)

$b_{11}$) Alkencarbonsäureester und/oder Alkencarbonylamino-N-methylenether von partiell oder nahezu vollständig hydrolysierten Polyvinylalkohol-alkancarbonsäureestern

und/oder

$b_{12}$) Alkencarbonsäureester und/oder Alkencarbonylamino-N-methylenether von partiell oder nahezu vollständig hydrolysierten Pfropfmischpolymerisaten aus Vinylalkohol-alkancarbonsäureestern und Alkylenoxiden

und als Monomer ($b_2$) Glycerol-tris(methacrylamido-N-methylen)ether enthält und daß sie mehr als 0,8 mm dick ist.

Im Hinblick auf den Stand der Technik war es überraschend, daß die erfindungsgemäßen Heißprägeplatten hervorragend für die Herstellung von besonders dicken, harten und zugleich thermostabilen Heißprägematrizen geeignet sind.

Wesentlicher Bestandteil der erfindungsgemäßen Heißprägeplatte ist ihre durch Photopolymerisation vernetzbare, in Wasser lösliche oder dispergierbare, reliefbildende Schicht (b).

Diese Schicht (b) weist eine Dicke von mehr als 0.8 mm auf. Erfindungsgemäß von Vorteil ist dabei eine Dicke im Bereich von 0,9 bis 2 mm, vorzugsweise 1 bis 1,7 mm und insbesondere 1,3 bis 1.6 mm.

Erfindungsgemäß enthält die Schicht (b) außer einem oder mehreren partiell oder nahezu vollständig hydrolysierten polyvinylalkohol-alkancarbonsäureestern, wie Polyvinylacetat, -propionat oder -butyrat [Polyvinylalkohol, Bindemittel ($b_1$)] noch weitere Bindemittel ($b_{11}$) und/oder ($b_{12}$) (Polyvinylalkoholderivate). Diese Polyvinylalkoholderivate ($b_{11}$) und ($b_{12}$) sind an sich bekannt und werden hergestellt durch polymeranaloge Veresterung von Polyvinylalkoholen mit Alkencarbonsäureanhydriden oder durch polymeranaloge Veretherung von Polyvinylalkoholen mit beispielsweise N-Methylolalkencarbonsäureamiden.

Vorteilhafterweise verwendet man hierzu die in Wasser löslichen oder dispergierbaren Polyvinylalkohole ($b_1$), welche wiederkehrende 1-Hydroxiethyliden-1,2-Einheiten

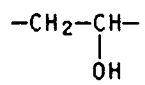

in der Polymerkette enthalten und zahlenmittlere Molgewichte $\overline{M}_n$ von $10^4$ bis $10^5$, insbesondere von $1{,}5 \cdot 10^4$ bis $5 \cdot 10^4$ aufweisen, beispielsweise partiell oder nahezu vollständig hydrolysiertes Polyvinylacetat oder -propionat mit einem Hydrolysegrad von 60 bis 99 %, vorzugsweise 70 bis 98 % und insbesondere 75 bis 95 %. Oder man verwendet hierzu die partiell oder nahezu vollständig hydrolysierten Alkylenoxid-Vinylalkoholalkancarbonsäureester-Pfropfmischpolymerisate ($b_1$), insbesondere solche, die durch Pfropfen von Vinylacetat oder -propionat auf Polyethylenoxid und anschließende Hydrolyse erhalten werden und aus - jeweils bezogen auf das Pfropfmischpolymerisat -

10 bis 30 Gew.-% an 1-Oxapropyliden-1,3-

$-CH_2-CH_2-O-$

0 bis 30 Gew.-% an 1-Acetyl-ethyliden-1,2-

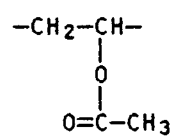

und 90 bis 40 Gew.-% an 1-Hydroxiethyliden-1,2-Einheiten bestehen.

Diese Polyvinylalkohole ($b_1$) können einzeln oder als Gemisch zu den Polyvinylalkoholderivaten ($b_{11}$) und ($b_{12}$) umgesetzt werden.

Die polymeranaloge Veresterung dieser Polyvinylalkohole ($b_1$) erfolgt in an sich bekannter Weise durch Dispergieren der Polyvinylalkohole in einer aprotischen Flüssigkeit, Zugabe von Alkencarbonsäureanhydriden im Überschuß und von Katalysatoren sowie dem Erwärmen des resultierenden Reaktionsgemisches für einige Stunden auf 40 bis 100°C, wonach man die Polyvinylalkoholderivate ($b_{11}$) oder ($b_{12}$) abfiltriert, wäscht und trocknet. Im allgemeinen sind dabei in dieser Weise 1 bis 20 Mol. -% der Hydroxigruppen des

Polyvinylalkohols umgesetzt worden.

Beispiele hierfür geeigneter Alkencarbonsäureanhydride sind Acrylsäureanhydrid, Methacrylsäureanhydrid oder Maleinsäureanhydrid.

Beispiele hierfür geeigneter Katalysatoren sind N-Alkylimidazole, wie N-Methylimidazol oder N-Ethylimidazol.

Die polymeranaloge Veretherung der Polyvinylalkohole ($b_1$) mit N-Methylol-, N-Methoximethyl- oder N-Ethoximethylamiden von Alkencarbonsäuren mit 3 bis 10 Kohlenstoffatomen, wie etwa Crotonsäure, Maleinsäure, Acrylsäure oder Methacrylsäure, kann wie in der EP-A 226 079 beschrieben, durchgeführt werden. Hierbei resultieren im allgemeinen Polyvinylalkoholderivate ($b_{11}$) oder ($b_{12}$), deren Hydroxigruppen zu 1 bis 20 Mol. -% umgesetzt worden sind.

In den reliefbildenden Schichten (b) der erfindungsgemäßen Heißprägeplatten liegt der Anteil der Bindemittel ($b_{11}$) und/oder ($b_{12}$) an dem gesamten Bindemittel ($b_1$) plus ($b_{11}$) und/oder ($b_{12}$) bei 10 bis 90, vorteilhafterweise 15 bis 80 und insbesondere 20 bis 70 Gew.-%. Dabei ist das Mengenverhältnis der Bindemittel ($b_{11}$) zu ($b_{12}$) frei wählbar. So kann allein das Bindemittel ($b_{11}$) oder das Bindemittel ($b_{12}$) mitverwendet werden. Es ist indes von Vorteil, ($b_{11}$) und ($b_{12}$) gemeinsam mitzuverwenden. Dabei ist es von besonderem Vorteil, wenn das Mengenverhältnis von ($b_{11}$) zu ($b_{12}$) größer als 1, vorzugsweise größer als 3 und insbesondere größer als 5, ist. Von ganz besonderem Vorteil ist es, lediglich das Bindemittel ($b_{11}$) zusammen mit dem Bindemittel ($b_1$) zu verwenden.

Außer den Bindemitteln ($b_1$) sowie ($b_{11}$) und/oder ($b_{12}$) enthalten die reliefbildenden Schichten (b) der erfindungsgemäßen Heißprägeplatten als Monomer ($b_2$) Glycerol-tris(methacrylamido-N-methylen)ether. Dessen Herstellung ist aus der JP-A- 124 730/82 bekannt.

In den reliefbildenden Schichten (b) ist das Monomere ($b_2$) in einer Menge von 20 bis 60, vorzugsweise 25 bis 55 und insbesondere 30 bis 50 Gew.-Teilen, pro 100 Gew.-Teilen des gesamten Bindemittels ($b_1$) plus ($b_{11}$) und/oder ($b_{12}$) enthalten.

Darüber hinaus enthalten die reliefbildenden Schichten (b) der erfindungsgemäßen Heißprägeplatten übliche und bekannte Photoinitiatoren ($b_3$), wie Benzildimethylacetal oder 2,4,6-Trimethylbenzoyldiphenylphosphinoxid, in einer Menge von 0,1 bis 15, vorzugsweise 0,5 bis 10 und insbesondere 1 bis 6 Gew.-Teilen, pro 100 Gew.-Teilen des gesamten Bindemittels ($b_1$) plus ($b_{11}$) und/oder ($b_{12}$).

Demnach enthalten ganz besonders vorteilhafte reliefbildende Schichten (b) im wesentlichen

- 100 Gew.-Teile Bindemittel, wobei der Anteil des Bindemittels ($b_1$) hieran bei 30 bis 80 Gew.-Teilen und der Anteil des Bindemittels ($b_{11}$) hieran bei 70 bis 20 Gew.-Teilen liegt,
- 30 bis 50 Gew.-Teile Glycerol-tris(methacrylamido-N-methylen)ether ($b_2$) und
- 1 bis 6 Gew.-Teile eines Initiators der Photopolymerisation ($b_3$).

Außerdem können die reliefbildenden Schichten (b) der erfindungsgemäßen Heißprägeplatten noch weitere geeignete Zusatzstoffe, wie übliche und bekannte Inhibitoren der thermisch initiierten Polymerisation, Farbstoffe, Pigmente, Weichmacher, Antioxidantien, photochrome Stoffe, Mittel zur Verbesserung der Reliefstruktur, Vernetzungshilfsmittel, Flußmittel, Trennmittel, Füllmittel und/oder Verstärkerfüllmittel, in wirksamen Mengen enthalten.

Die Herstellung der reliefbildenden Schichten (b) der erfindungsgemäßen Heißprägeplatten aus ihren Bestandteilen bietet keine methodischen Besonderheiten, sondern es können hierbei die üblichen und bekannten Knet-, Misch- und Lösungstechniken für die Vermischung der Bestandteile angewendet werden. Die so erhaltenen Gemische können dann in üblicher Weise durch Gießen aus einer Lösung, Heißpressen, Kalandrieren oder Extrudieren zu Schichten (b) der gewünschten Dicke geformt werden.

Ein weiterer wesentlicher Bestandteil der erfindungsgemäßen Heißprägeplatten ist der hitzebeständige und dimensionsstabile Träger (a). Hierfür kommen vor allem 0,2 bis 2 mm dicke Platten aus Metallen wie Stahl, Aluminium, Kupfer oder Nickel in Betracht.

Vorteilhafterweise ist in den erfindungsgemäßen Heißprägeplatten die reliefbildende Schicht (b) mit dem Träger (a) haftfest verbunden.

Des weiteren kann auf diejenige Seite der Schicht (b), die dem Träger (a) abgewandt ist, eine Deckschicht (DS) und/oder eine Deckfolie (DF) aufgebracht werden. Werden Deckschicht (DS) und Deckfolie (DF) gemeinsam verwendet, dann liegt (DS) der Schicht (b) direkt auf, und es kann sich zwischen (DS) und (DF) noch eine Antihaftschicht (AS) befinden. Ferner kann eine haftfeste Verbindung zwischen dem Träger (a) und der Schicht (b) mit Hilfe einer Haftschicht (HS) erzielt werden.

Als Haftschichten (HS) können übliche und bekannte 0,5 bis 40 µm dicke Haftlackschichten verwendet werden.

Übliche Deckschichten (DS) sind 0,5 bis 20 µm dick und können aus einem Polymeren bestehen, das lösliche, klebfreie, transparente und reißfeste Filme bildet, z.B. Polyamid, Copolyamid, Polyurethan, Polyvinylalkohol, Polyvinylpyrrolidon, Polyethylenoxid eines Molgewichts über 105 oder Cyclokautschuk mit einem

hohen Cyclisierungsgrad. Gegebenenfalls kann (DS) mattiert sein.

Übliche Deckfolien (DF) sind 20 bis 150 µm dick und bestehen einem Polymeren wie Polyamid oder Polyethylenterephthalat.

Übliche Antihaftschichten (AS) sind 0,1 bis 0,5 µm dick und bestehen beispielsweise aus Silikonharzen.

Werden als Träger (a) stark reflektierende Platten verwendet, dann können auf ihre Oberfläche übliche Lichthofschutzmittel, wie Ruß, Mangandioxid, migrationsechte Farbstoffe oder Pigmente, als separate Schicht aufgetragen werden. Die Lichthofschutzmittel können aber auch in der Haftschicht (HS) oder in der reliefbildenden Schicht (b) enthalten sein.

Die Herstellung der erfindungsgemäßen Heißprägeplatten weist keine methodischen Besonderheiten auf. Üblicherweise erfolgt sie durch Auftragen der reliefbildenden Schicht (b) auf der Träger (a) mittels Gießen aus Lösung, Heißpressen, Kalandrieren oder Extrudieren. Auf dieses Zweischichtenelement können dann die anderen Schichten in bekannter Weise aufgebracht werden. Es ist aber auch möglich, die Schicht (b) zuerst auf die mit einer Deckschicht (DS) bedeckten Seite einer Deckfolie (DF) aufzutragen und anschließend die unbedeckte Seite der Schicht (b) mit dem Träger (a) haftfest zu verbinden.

Aus den erfindungsgemäßen Heißprägeplatten werden in üblicher Weise durch Photopolymerisation vernetzte Heißprägematrizen hergestellt. Die Herstellung bietet keine methodischen Besonderheiten, sondern erfolgt - gegebenenfalls nach einer Vorbehandlung - durch bildmäßiges Belichten der Heißprägeplatten mit aktinischem Licht einer Wellenlänge $\lambda$ zwischen 300 und 450 nm, vorteilhafterweise zwischen 320 und 420 nm, durch aufgelegte Negativvorlagen hindurch, Auswaschen der unbelichteten und daher unvernetzten Anteile der Heißprägeplatte mit Wasser oder Wasser/Alkoholgemischen und Trocknen der in dieser Weise erhaltenen durch Photopolymerisation vernetzten Heißprägematrizen, welche nun eine Reliefschicht (b′) enthalten. Anschließend kann eine Nachbehandlung erfolgen.

Eine übliche Vorbehandlung ist z.B. das Abziehen einer gegebenenfalls vorhandenen Deckfolie (DF).

Übliche Nachbehandlungen sind das vollflächige Nachbelichten oder das Trocknen der durch Photopolymerisation vernetzten Heißprägematrizen.

Geeignete Lichtquellen für aktinisches Licht sind z.B. handelsübliche UV-Fluroeszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Die Dicke der Reliefschicht (b′) der so erhaltenen Heißprägematrizen ist im allgemeinen größer als 0,8 mm; von Vorteil sind Dicken von 0,9 bis 2 mm, vorzugsweise 1 bis 1,7 mm und insbesondere 1,3 bis 1,6 mm.

Die erfindungsgemäßen Heißprägeplatten weisen bei ihrer Herstellung und Verarbeitung zahlreiche besondere unerwartete Vorteile auf. So lassen sie sich aufgrund der hohen thermischen Stabilität ihrer reliefbildenden Schicht (b) sehr leicht nach den üblichen Verfahren herstellen und verarbeiten, ohne daß hierzu besondere Vorsichtsmaßnahmen notwendig werden. Sie sind lagerstabil und lassen sich umweltfreundlich entsorgen.

Die Heißprägerplatten können in kürzerer Zeit belichtet und entwickelt werden als die entsprechenden bekannten Produkte, so daß insgesamt kürzere Verfahrenszeiten und somit höhere Raum/Zeit-Ausbeuten bei der Herstellung von Heißprägematrizen resultieren. Darüber hinaus können die trocknungszeiten für die belichteten und entwickelten Heißprägematrizen verkürzt werden, weil deren hervorragendes anwendungstechnisches Eigenschaftsprofil durch einen vergleichsweise hohen Restwassergehalt in den Reliefschichten (b′) nicht verschlechtert wird.

Überdies sind die Reliefschichten (b′) der Heißprägematrizen so hart, temperaturbeständig und dimensionsstabil, daß sie selbst nach 10-facher Verwendung zum Heißprägen keine nachteiligen Veränderungen erleiden.

Beispiel 1

Die Herstellung von Polyvinylalkoholderivaten (Bindemittel $b_{11}$ und $b_{12}$)

Für die weiteren Beispiele und Vergleichsversuche wurden teilveresterte und teilveretherte Polyvinylalkohole nach den folgenden Vorschriften hergestellt:

1.1. Herstellung eines Polyvinylalkohol-methacrylsäureesters (Bindemittel $b_{11}$)

1000 kg eines partiell hydrolysierten Polyvinylacetates (Hydrolysegrad: 82 Mol.-%; zahlenmittleres Molekulargewicht $\overline{M}_n$: $2 \cdot 10^4$) wurden in einer Mischung aus 1800 kg Toluol, 165 kg Methacrylsäureanhydrid (enthaltend 3,5 % Methacrylsäure als Verunreinigung), 10 kg 2,6-Di-tert.-butyl-p-kresol und 5 kg N-Methylimidazol dispergiert. Das resultierende Gemisch wurde während 8 Stunden bei 90 °C gerührt, wonach das entstandene Reaktionsprodukt abfiltriert, mit Toluol und Aceton gewaschen und anschließend getrocknet wurde. Es enthielt 5,5 Gew.-% an Methacrylatgruppen. Es war frei von Nebenprodukten und praktisch farblos.

1.2 Herstellung eines Polyvinylalkohol-methacrylsäureesters (Bindemittel $b_{12}$)

Es wurde wie in (1.1) verfahren, nur daß anstelle des partiell hydrolysierten Polyvinylacetates ein partiell hydrolysiertes Ethylenoxid-Vinylacetate-Pfropfmischpolymerisat eines zahlenmittleren Molgewichts $\overline{M}_n$ von $2 \cdot 10^4$, bestehend aus, bezogen auf das Pfropfcopolymerisat, 25 Gew.-% 1-Oxapropyliden-1,3-, 25 Gew.-% 1-Acetyl-ethyliden-1,2- und 50 Gew.-% 1-Hydroxi-ethyliden-1,2-Einheiten, verwendet wurde. Das entstandene Reaktionsprodukt enthielt 61, Gew.-% an Methacrylatgruppen. Es war frei von Nebenprodukten.

1.3 Herstellung eines Polyvinylalkohol-acrylamido-N-methylenethers (Bindemittel $b_{11}$)

100 kg des Polyvinylalkohols aus (1.1) wurden zusammen mit 2 kg 2,6-Di-tert.-butyl-p-kresol, 2 kg 69%iger wäßriger Phosphorsäure und 18,7 kg N-Methylolacrylamid in 130 kg Wasser gelöst. Die resultierende Lösung wurde über einen Dünnschichtverdampfer geleitet, dabei aufkonzentriert und anschließend auf Bleche ausgegossen. Die so erhaltenen nassen Filme wurde getrocknet, während 1 Stunde bei 100 °C getempert und anschließend zerkleinert. Das zerkleinerte Produkt wurde in 0,07%iger wäßriger Natronlauge gelöst und das unumgesetzte N-Methylolacrylamid durch Dialyse daraus abgetrennt. Anschließend wurde das gereinigte Produkt durch Zugabe von Säure aus der Lösung ausgefällt, von dieser abgetrennt und getrocknet.

Das IR-Spektrum des teilveretherten Polyvinylalkohols zeigte die Banden der Acrylamidgruppen bei 1650, 1620 und 1520 $cm^{-1}$. Die Ausbeute an Methylenethergruppen betrug 62 %, bezogen auf N-Methylolacrylamid, entsprechend einem Gehalt von etwa 10 Gew.-% an Acrylamido-N-methylengruppen in Umsetzungsprodukt.

1.4 Herstellung eines Polyvinylalkohol-(methacrylamido-N-methylen)ethers (Bindemittel $b_{12}$)

Es wurde im wesentlichen wie in (1.3) verfahren, nur daß anstelle des dort verwendeten Polyvinylalkohols und des N-Methylolacrylamids, der Polyvinylalkohol aus (1.2) und N-Methylolmethacrylamid zur Anwendung kamen.

Das Umsetungsprodukt enthielt 11 Gew.-% an Methacrylamido-N-methylengruppen.

Beispiel 2

Die Herstellung von Heißprägeplatten und -matrizen; Herstellungsvorschrift

Die reliefbildenden Schichten (b) der erfindungsgemäßen Heißprägeplatten wurden über das Lösen ihrer Bestandteile in Wasser/Isopropanol (Volumenverhältnis 70:30) hergestellt. Die Tabelle 1 gibt Auskunft über die Art und die Mengenverhältnisse der Bestandteile.

Die Lösungen wurden auf 1 mm dicke, 25 cm breite und 30 cm lange Aluminiumbleche gegossen und getrocknet, so daß reliefbildende Schichten (b) einer Trockenschichtdicke von 1,5 mm resultierten.

Die so erhaltenen Heißprägeplatten (2.1) bis (2.4), Tabelle 1, wurden mit einem Flachbelichter mit superaktinischen Leuchtstoffröhren während 6 Minuten durch ein Standardnegativ hindurch bildmäßig belichtet und dann mit Leitungswasser in einem Durchlaufwascher 7 Minuten lang entwickelt. Anschließend wurden die Heißprägematrizen 2 Stunden lang getrocknet.

Die durch Photopolymerisation vernetzten Heißprägematrizen (2.1) bis (2.4), Tabelle 1, wurden zum Prägen von für den Flexodruck typischen Gummiklischees verwendet. Hierzu wurden die Heißprägematrizen zunächst mit einem handelsüblichen Entformungshilfsmittel auf Talkumbasis vorbehandelt. Anschließend wurde jede der Heißprägeplatten zusammen mit jeweils einer handelsüblichen Heißprägemater auf der Basis eines mit einem Phenolharz getränkten und beschichteten Faserkartons (Dicke der Beschichtung 1,3 mm) in eine heizbare Prägepresse eingelegt und während 2 Minuten bei minimalem Anpreßdruck auf 140 bis 150 °C vorgewärmt. Danach wurden die beiden Pressestempel stets mit einem Druck von 20 Tonnen gegeneinander gefahren, wobei der Druck immer durch zwei neben die Heißprägemater gelegte Distanzleisten so aufgefangen wurde, daß die Eindringtiefe der Oberfläche der Heißprägematrizen in die Heißprägematern jeweils 1,6 mm betrug. Anschließend wurden die Heißprägematern im Kontakt mit den Heißprägematrizen bei etwa 145 °C während 18 Minuten in der Prägepresse ausgehärtet. Nach dem Abtrennen der Heißprägematrizen wurden hervorragend ausgebildete Heißprägematern erhalten, welche dann in üblicher und bekannter Weise mit flächenförmigen Kautschukschichten verpreßt wurden. Diese flächenförmigen Kautschukschichten enthielten nun Reliefs, welche in ihrer Qualität und Detailtreue den ursprünglichen Reliefschichten (b′) der Heißprägematrizen voll und ganz entsprachen. Die Kautschukschichten wurden zu Gummiklischees für den Flexodruck ausvulkanisiert. Beim Drucken auf einem handelsüblichen Druckwerk gaben die Gummiklischees die in der ursprünglichen Bildvorlage enthaltene und über die erfindungsgemäßen Heißprägeplatten auf sie übertragenen Information in hervorragender Weise wieder. Dabei waren auch die feinsten Bildelemente sehr sauber und exakt ausgeprägt.

Die bildmäßige Information der vier Heißprägematrizen ließ sich selbst nach 20 Prägervorgängen noch immer ohne Deformationen oder Informationsverluste auf die Gummiklischees übertragen.

Tabelle 1: Erfindungsgemäße Heißprägeplatten

| reliefbildende Schicht (b) und Heißprägeplatte Nr. | Polyvinylalkohol-derivat (Nr.) Gew.-Tle. | Polyvinyl-alkohol 1) Gew.-Tle. | Monomer 2) Gew.-Tle. | Photo-initiator 3) Gew.-Tle. | Inhibitor der thermischen Polymerisation 4) Gew.-Tle. |
|---|---|---|---|---|---|
| 2.1 | (1.1) 62,5 | 37,5 | 43,7 | 3,75 | 0,625 |
| 2.2 | (1.2) 62,5 | 37,5 | 43,7 | 3,75 | 0,625 |
| 2.3 | (1.3) 62,5 | 37,5 | 43,7 | 3,75 | 0,625 |
| 2.4 | (1.4) 62,5 | 37,5 | 43,7 | 3,75 | 0,625 |

1) partiell hydrolysiertes Polyvinylacetat, Hydrolysegrad 80 %, zahlenmittleres Molgewicht $\overline{M}_n$: $2 \cdot 10^4$;
2) Glycerol-tris(methacrylamido-N-methylen)ether;
3) Benzildimethylacetal;
4) Kaliumsalz des N-Nitroso-cyclohexylhydroxylamins;

Vergleichsversuch

Die Herstellung von nicht erfindungsgemäßen Heißprägeplatten

Es wurde im wesentlichen wie in Beispiel 2 verfahren, nur daß die reliefbildenden Schichten die in der Tabelle 2 angegebenen Zusammensetzungen aufwiesen.

Die durch Photopolymerisation vernetzten Heißprägeplatten V1 bis V4 eigneten sich nicht für das Heißprägen von flexotypischen Gummidruckplatten, weil bereits beim ersten Prägevorgang Risse und Deformationen und damit Informationsverluste auftraten.

Die Heißprägematrize V1 zeigte dabei zusätzlich eine mangelhafte Ausbildung feinster punkt- oder linienförmiger Reliefteile.

Tabelle 2: Heißprägeplatten auf der Grundlage bekannter reliefbildender Schichten (Vergleichsversuche)

| reliefbildende Schicht und Heißprägeplatte | Polyvinylalkohol-derivat (Nr.) | Polyvinyl-alkohol 1) | Monomer | Photo-initiator 4) | Inhibitor der thermischen Polymerisation 5) |
|---|---|---|---|---|---|
| Nr. | Gew.-Tle. | Gew.-Tle. | Gew.-Tle. | Gew.-Tle. | Gew.-Tle. |
| V 1 | - | 100 | 53,8 2) | 3,7 | 0,625 |
| V 2 | (1.1) 61,5 | 38,5 | 53,8 3) | 3,7 | 0,625 |
| V 3 | (1.3) 100 | - | - | 3,7 | 0,625 |
| V 4 | (1.4) 100 | - | - | 3,7 | 0,625 |

1) partiell hydrolysiertes Polyvinylacetat, Hydrolysegrad 80 %, zahlenmittleres Molgewicht $\overline{M}_n$: $2 \cdot 10^4$;
2) Glycerol-tris(methacrylamido-N-methylen)-ether;
3) Tetraethylenglykol-dimethacrylat;
4) Benzildimethylacetal;
5) Kaliumsalz des N-Nitroso-cyclohexylhydroxylamins;

**Patentansprüche**

**1.** Durch Photopolymerisation vernetzbare Heißprägeplatten, welche
a) einen hitzebeständigen, dimensionsstabilen Träger und

b) eine durch Photopolymerisation vernetzbare, in Wasser lösliche oder dispergierbare, reliefbildende Schicht, enthaltend

$b_1$) einen oder mehrere partiell oder nahezu vollständig hydrolysierte Polyvinylalkohol-alkancarbonsäureester als Bindemittel,

$b_2$) einen Alkencarbonylamino-N-methylenether mehrwertiger Alkohole als photopolymerisierbars Monomer und

$b_3$) Initiatoren der Photopolymerisation,

aufweisen, dadurch gekennzeichnet, daß die reliefbildende Schicht (b) als weitere Bindemittel ($b_1$)

$b_{11}$) Alkencarbonsäureester und/oder Alkencarbonylamino-N-methylenether von partiell oder nahezu vollständig hydrolysierten Polyvinylalkohol-alkancarbonsäureestern

und/oder

$b_{12}$) Alkencarbonsäureester und/oder Alkencarbonylamino-N-methylether von partiell oder nahezu vollständig hydrolysierten Pfropfmischpolymerisaten aus Vinylalkohol-alkancarbonsäureestern und Alkylenoxiden,

und als Monomer ($b_2$) Glycerol-tris(methacrylamido-N-methylen)ether enthält und daß sie mehr als 0,8 mm dick ist.

**2.** Verfahren zur Herstellung einer durch Photopolymerisation vernetzten Heißprägematrize, bei welchem man die durch Photopolymerisation vernetzbare, reliefbildende Schicht (b) einer Heißprägeplatte mit aktinischem Licht bildmäßig belichtet und anschließend die belichtete Schicht mit Wasser entwickelt, dadurch gekennzeichnet, daß man hierfür eine Heißprägeplatte gemäß Anspruch 1 verwendet.

## Claims

**1.** A hot stamping plate crosslinkable by photopolymerization, which has

a) a heat-resistant, dimensionally stable substrate and

b) a relief-forming layer which is crosslinkable by photopolymerization and soluble or dispersible in water and contains

$b_1$) one or more partially or virtually completely hydrolyzed polyvinyl alkanecarboxylates as binders,

$b_2$) an alkenecarbonylamino-N-methylene ether of a polyhydric alcohol as a photopolymerizable monomer and

$b_3$) photopolymerization initiators,

wherein the relief-forming layer (b) contains, as further binders ($b_1$),

$b_{11}$) alkenecarboxylates and/or alkenecarbonylamino-N-methylene ethers of partially or virtually completely hydrolyzed polyvinyl alkanecarboxylates

and/or

$b_{12}$) alkenecarboxylates and/or alkenecarbonylamino-N-methyl ethers of partially or virtually completely hydrolyzed graft copolymers of vinyl alkanecarboxylates and alkylene oxides

and, as monomer ($b_2$), glyceryl tris(methacrylamido-N-methylene) ether

and is more than 0.8 mm thick.

**2.** A process for the production of a hot stamping die crosslinked by photopolymerization, in which the relief-forming layer (b) of a hot stamping plate, which layer is crosslinkable by photopolymerization, is exposed imagewise to actinic light and the exposed layer is then developed with water, wherein a hot stamping plate as claimed in claim 1 is used for this purpose.

## Revendications

**1.** Plaques d'estampage à chaud réticulables par photopolymérisation, qui comportent :

a) un support à dimensions stables, résistant à la chaleur, et

b) une couche formant relief, soluble ou dispersable dans l'eau, réticulable par photopolymérisation, contenant

b1) un ou plusieurs esters alcanoïques de l'alcool polyinylique partiellement ou presque complètement hydrolysés en tant que liant,

b2) un alcène-carbonylamino-N-méthylène-éther d'alcool polyvalent en tant que monomère photopolymérisable, et

b3) des inducteurs de la photopolymérisation,

caractérisées en ce que la couche formant le relief b) contient en tant qu'autres liants b1)

b11) des esters d'acides alcénoïques et des alcènecarbonylamino-N-méthylène-éthers d'esters alcanoïques de l'alcool polyvinylique partiellement ou presque complètement hydrolysés;

et/ou

b12) des esters alcénoïques et/ou des alcènecarbonylamino-N-méthyl-éthers de copolymères greffés partiellement ou presque complètement hydrolysés d'esters alcanoïques de l'alcool vinylique et d'oxydes d'alkylène, et en tant que monomère b2) le tris-(méthacrylamido-N-méthylène)-éther du glycérol, et en ce qu'elle a une épaisseur supérieure à 0,8 mm.

**2.** Procédé de préparation d'une matrice d'estampage à chaud réticulée par photopolymérisation dans lequel on expose à la lumière actinique avec formation d'une image la couche formant le relief b), réticulable par photopolymérisation, d'une plaque d'estampage à chaud puis on développe la couche exposée à la lumière par l'eau, caractérisé en ce que l'on utilise à cet effet une plaque d'estampage à chaud selon la revendication 1.